# EUROPÄISCHE PATENTSCHRIFT

(11) **EP 1 228 571 B1**
(45) Veröffentlichungstag und Bekanntmachung des Hinweises auf die Patenterteilung: **15.12.2004**
(21) Anmeldenummer: 00951519.8
(22) Anmeldetag: 16.08.2000
(51) Int. Cl.: H04B 1/16

(54) **VERFAHREN ZUR REDUKTION VON EMPFANGSSTÖRUNGEN, INSBESONDERE VON MEHRWEGEMPFANGSSTÖRUNGEN, BEIM EMPFANG EINES RUNDFUNKSIGNALS SOWIE EINE SCHALTUNGSANORDNUNG ZUR DURCHFÜHRUNG DES VERFAHRENS**
METHOD FOR REDUCING RECEPTION INTERFERENCES, ESPECIALLY MULTIWAY RECEPTION INTERFERENCES, FOR RECEIVING A RADIO SIGNAL AND CIRCUIT FOR CARRYING OUT THIS METHOD
PROCEDE DE REDUCTION DE PERTURBATIONS DE RECEPTION, NOTAMMENT DE PERTURBATIONS DE RECEPTION PAR TRAJETS MULTIPLES, LORS DE LA RECEPTION D'UN SIGNAL RADIO ET CIRCUIT CORRESPONDANT

(30) Priorität: 08.09.1999 DE 19942889
(43) Veröffentlichungstag der Anmeldung: 07.08.2002
(73) Patentinhaber: Volkswagen Aktiengesellschaft, 38436 Wolfsburg (DE)
(72) Erfinder: BEYER, Detlev, D-38550 Isenbüttel (DE)
(86) Internationale Anmeldenummer: PCT/EP2000/007998
(87) Internationale Veröffentlichungsnummer: WO 2001/018979

(56) Entgegenhaltungen:
- EP-A- 0 304 923
- US-A- 4 208 547

## Beschreibung

Die Erfindung betrifft ein Verfahren zur Erkennung und Reduzierung von Empfangsstörungen, insbesondere von Mehrwegempfangstörungen, in einem Eingangssignal eines Rundfunkempfängers, bei dem in einer Detektoreinrichtung das Auftreten einer derartigen Empfangsstörung detektiert und ein entsprechendes Detektorsignal zu einer dieses Detektorsignal auswertenden Verarbeitungseinrichtung geleitet wird, wobei von der Verarbeitungseinrichtung ein entsprechendes Steuersignal erzeugt und zu einer Audioeinheit geleitet wird, durch die ein Audiosignal erzeugbar ist, welches in einem von einer unteren und einer oberen Grenzfrequenz begrenzten Frequenzintervall liegt, und bei dem durch die Audioeinheit eine Absenkung des Pegels des von ihr aus dem Eingangssignal erzeugten Audiosignals im Frequenzbereich über einer unter der vorgenannten oberen Grenzfrequenz des Audiosignals liegenden, abgesenkten oberen Grenzfrequenz durchgeführt wird.

In der DE 197 22 385 ist ein Verfahren mit den vorstehend genannten Merkmalen sowie eine derartige Schaltungsanordnung beschrieben. Hierbei ist vorgesehen, daß zur Erkennung und Reduzierung von Mehrwegempfangstörungen in einem Rundfunksignal das Eingangssignal, welches mit Mehrwegempfangstörungen behaftet ist, hochpaßgefiltert wird, damit die niederfrequenten Signalanteilen vom Eingangssignal ausgefiltert werden. Das derart gefilterte Eingangssignal wird dann verstärkt, damit die hochfrequenten Signalanteile eine Pegelanhebung erfahren. Das gefilterte und verstärkte Eingangssignal wird dann auf charakteristische Impulse, welche typischerweise bei Mehrwegempfangstörungen auftreten, durchsucht. Diese Störimpulse werden dann, wenn sie einen vorher festgelegten Signalpegel aufweisen, erfaßt und verbreitert, wodurch die Signalenergie dieser Impulse vergrößert wird. Aus diesem Signal werden über jeweils mindestens ein Zeitkonstantenglied weitere Signale zur Ansteuerung der dynamischen Höhenabsenkung des Audiosignals, der Stereo-Monoüberblendung und/oder der Lautstärkebeeinflussung gewonnen, Insbesondere ist hierbei vorgesehen, daß die obere Grenzfrequenz des Audiosignals abgesenkt wird.

Das bekannte Verfahren besitzt den Nachteil, daß bei der vorgesehenen Absenkung der hochfrequenten Anteile des von der Audioeinheit erzeugten Audiosignals in nachteiliger Art und Weise das Klangbild verändert wird (es "kippt"), welches somit nicht mehr ausgewogen ist. Das Audiosignal vermittelt einen dumpfen Klang, insbesondere, wenn die Höhenabsenkung über längere Zeit andauert.

Es ist daher Aufgabe der Erfindung, ein Verfahren der eingangs genannten Art sowie eine zur Durchführung des Verfahrens geeignete Schaltungsanordnung derart weiterzubilden, daß beim Auftreten von Empfangsstörungen, insbesondere von Mehrwegempfangsstörungen, die bei einem bekannten Verfahren in einer Absenkung der hochfrequenten Audiosignalanteile resultieren, ein verbessertes Klangbild erzielt wird.

Diese Aufgabe wird durch das erfindungsgemäße Verfahren dadurch gelöst, daß gleichzeitig zur Pegelabsenkung des Audiosignals im Frequenzbereich über der abgesenkten oberen Grenzfrequenz eine entsprechende Pegelabsenkung des Audiosignals im Bereich unter einer über der vorgenannten unteren Grenzfrequenz liegenden, angehobenen unteren Grenzfrequenz durchgeführt wird.

Durch die erfindungsgemäßen Maßnahmen wird auf vorteilhafte Art und Weise eine Verbesserung des Klangbilds auch beim Auftreten von akustisch wahrnehmbaren Empfangsstörungen, insbesondere von Mehrwegempfangstörungen, erreicht. Das durch das erfindungsgemäße Verfahren modifizierte Audiosignal zeichnet sich in besonders vorteilhafter Art und Weise durch eine Ausgewogenheit seines Klangbildes aus, auch wenn - bedingt durch das Auftreten der vorgenannten Empfangsstörungen - von der Audioeinheit die hochfrequenten Anteile des von ihr erzeugten Audiosignals abgesenkt werden.

Eine vorteilhafte Weiterbildung der Erfindung sieht vor, daß die Festlegung der angehobenen unteren Grenzfrequenz derart erfolgt, daß das Produkt aus der angehobenen unteren Grenzfrequenz und der abgesenkten oberen Grenzfrequenz ungefähr 400.000 beträgt. Eine derartige Anpassung der unteren Grenzfrequenz besitzt den Vorteil, daß hierdurch einem Kippen des durch das Audiosignal vermittelten Klangbildes besonders wirksam entgegengewirkt wird.

Eine weitere vorteilhafte Weiterbildung der Erfindung sieht vor, daß zusätzlich zur erfindungsgemäß vorgesehenen gleichzeitigen Absenkung des Audiosignals unter der angehobenen unteren Grenzfrequenz und über der abgesenkten oberen Grenzfrequenz ein Lautstärke-Ausgleich erfolgt, indem die Verstärkung des Audiosignals derart angehoben wird, daß der über den Frequenzverlauf zwischen der angehobenen unteren Grenzfrequenz und der abgesenkten oberen Grenzfrequenz integrierte Lautstärkepegel des Audiosignals im wesentlichen gleich dem entsprechenden Integral in den Grenzen der ursprünglichen unteren und oberen Grenzfrequenz ist. Eine derartige Maßnahme trägt in vorteilhafter Art und Weise zur weiteren Verbesserung des Klangbildes eines Audiosignals, welches mit Empfangsstörungen, insbesondere mit Multiwegeempfangsstörungen, behaftet ist, bei.

Weitere vorteilhafte Weiterbildungen der Erfindung sind Gegenstand der Unteransprüche.

Weitere Einzeleinheiten und Vorteile der Erfindung sind dem Ausführungsbeispiel zu entnehmen, daß im folgenden anhand der Figuren beschrieben wird.

Es zeigen:
- Figur 1: ein Ausführungsbeispiel einer Schaltungsanordnung zur Durchführung des Verfahrens,
- Figur 2: eine diagrammatische Darstellung des Lautstärkepegels des Audiosignals über dem Frequenzverlauf.

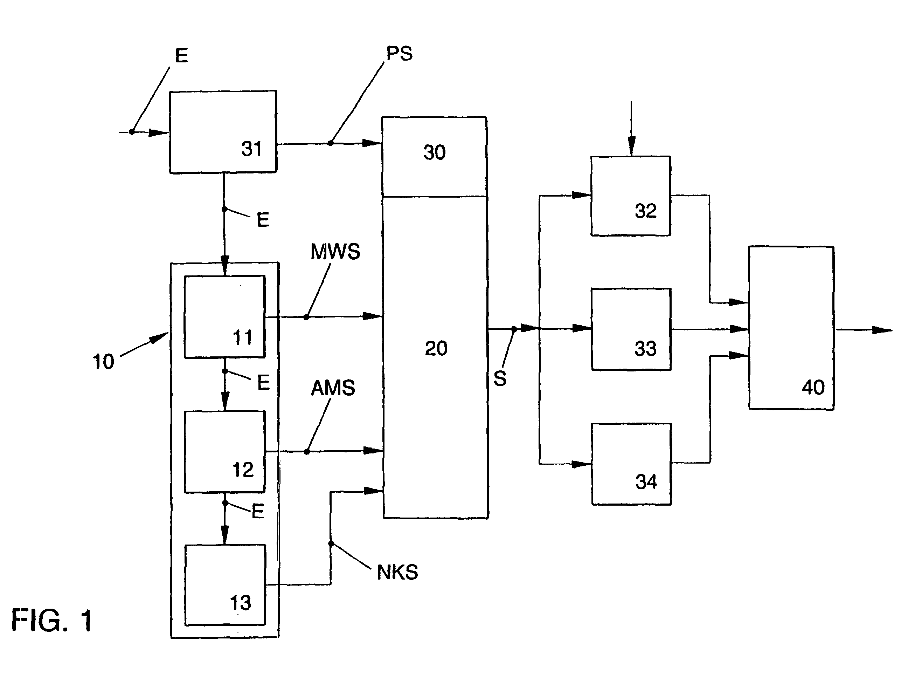

In Figur 1 ist nun ein Ausführungsbeispiel einer allgemein mit 1 bezeichneten Schaltungsanordnung zur Durchführung eines Verfahrens zur Selektion und Reduktion von Empfangsstörungen, insbesondere von Multiwegempfangsstörungen, eines Audiosignals dargestellt, welche sich im wesentlichen in eine Detektoreinheit 10, eine Verarbeitungseinrichtung 20, welcher die von der Detektoreinheit 10 erzeugten Detektorsignale zugeführt werden, und eine Audioempfangseinheit 30, welche aus dem empfangenen und in einem Frequenzmodulator 31 demodulierten Rundfunksignal ein Audiosignal erzeugt, das einem Audioverstärker 40 zugeführt wird, dessen Ausgangssignal in an für sich bekannter und daher nicht näher beschriebener Art und Weise zu in Figur 1 nicht dargestellten Lautsprechern geführt wird, gliedert. Die Detektoreinheit 10 weist einen Mehrwegempfangsstörungsdetektor 11 auf, durch den in an und für sich bekannter und daher ebenfalls nicht mehr näher beschriebenen Art und Weise Mehrwegempfangstörungen detektierbar sowie ein das Auftreten derartiger Störungen charakterisierendes Steuersignal MWS erzeugbar ist. Ein derartiger Mehrwegempfangsstörungsdetektor ist zum Beispiel in der DE 197 22 385 beschrieben, so daß zur Vermeidung von Wiederholungen auf diese Druckschrift bezuggenommen wird und deren technische Lehre durch diese Bezugnahme explizit zum inhalt der Offenbarung dieser Anmeldung gemacht wird.

Desweiteren kann die Detektoreinheit 10 noch eine AM-Detektoreinrichtung 12, durch die AM-Anteile im Eingangssignal E detektierbar und ein entsprechendes Steuersignal AMS erzeugbar ist, sowie eine NK-Detektoreinrichtung 14, durch die von Nachbarkanälen verursachte Störungen des Eingangssignals E detektierbar und ein Störungssignal NKS erzeugbar ist, aufweisen.

Ein den Pegel des Eingangssignals E charakterisierendes, vom Frequenzdemodulator 31 aus dem Eingangssignal E erzeugtes Signal PS sowie die Empfangsstörungen charakterisierende Steuersignale MWS, AMS und NKS werden nun zu der Audioeinheit 30 bzw. zu der Verarbeitungseinrichtung 20 geleitet, die aus den ihr zugeführten Steuersignalen MWS, AMS, NKS die Stärke der durch die einzelnen Störungen resultierenden Gesamtstörung und/oder die Häufigkeit dieser. Gesamtstörung ermittelt. Liegt nun die Stärke und/oder die Häufigkeit der Gesamtstörung über einem definierten Grenzwert, so wird von der Verarbeitungseinrichtung 20 ein Steuersignal S erzeugt, welches frequenz- und/oder lautstärkebeeinflussenden Reglern 32-34 der Audioeinheit 30 zugeführt wird.

Hierbei ist noch auszuführen, daß die Verarbeitungseinheit 20 und die Audioeinheit 30 als voneinander unabhängige Bauteile ausgeführt sein können. Da aber in zunehmendem Maße moderne Audioanlagen für Kraftfahrzeuge als DSP-(Digital Signal Processing)-Empfänger ausgebaut sind, bei denen die Verarbeitung des Audiosignals digital erfolgt, ist es - wie in Figur 1 angedeutet - oft der Fall, daß die Audioeinheit 30 und die Verarbeitungseinheit 20 als Funktionsgruppen ein und desselben integrierten Bausteins ausgeführt sind. In diesem Fall beinhaltet das Steuersignal S nicht nur die Information über das Auftreten einer Empfangsstörung, sondern auch eine die Audioinformation beinhaltende Signalkomponente.

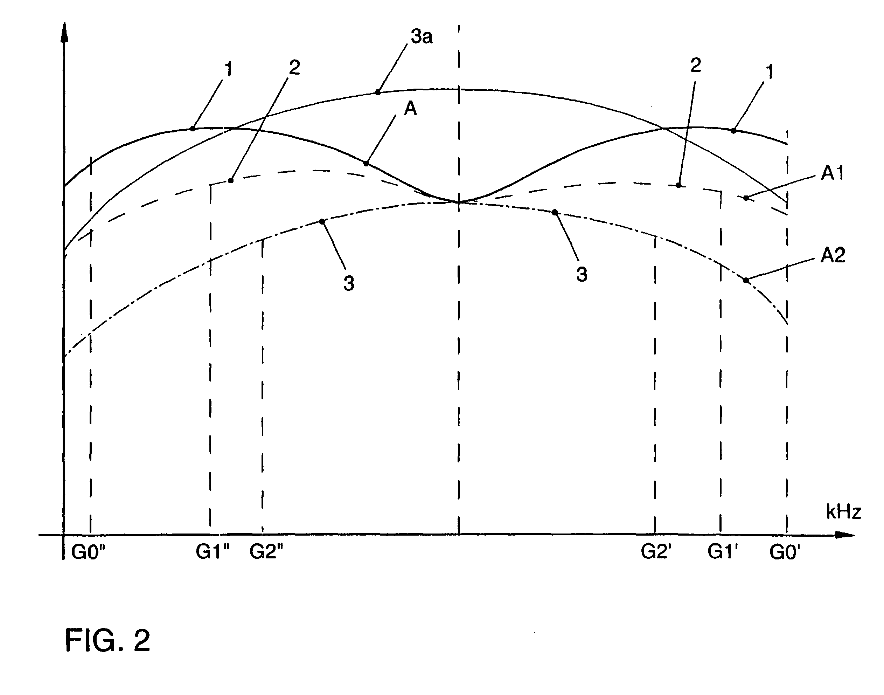

In Abwesenheit des das Auftreten einer zu korrigierenden oder kompensierenden Störung charakterisierenden Steuersignal S erzeugt die Audioeinheit 30 aus dem ihr zugeführten Ausgangssignal PS des Frequenzdemodulators 31 ein Audiosignal A, welches - wie aus der Figur 2 ersichtlich ist - in einem von einer unteren Grenzfrequenz G0" und einer oberen Grenzfrequenz G0' begrenzten Frequenzbereich liegt. Unter dem Begriff "Grenzfrequenz" wird hier üblicherweise die Frequenz verstanden, bei der ein Signalpegel auf -3dB abgefallen ist.

Empfängt nun die Audioeinheit 30 das Steuersignal S, so wird eine Absenkung der ursprünglichen oberen Grenzfrequenz G0' auf eine abgesenkte obere Grenzfrequenz G1' durchgeführt. Dies resultiert in einer Pegelabsenkung der über der abgesenkten oberen Grenzfrequenz G1' liegenden hochfrequenten Anteile des von der Audioeinheit 30 erzeugten Audiosignals A. Gleichzeitig wird eine entsprechende Anhebung der ursprünglichen unteren Grenzfrequenz G0" auf eine angehobene untere Grenzfrequenz G1" durchgeführt. Dies bewirkt, daß der Pegel des Audiosignals unter der angehobenen unteren Grenzfrequenz G1" abgesenkt wird. Diese Pegelabsenkung unter der angehobenen unteren und über der abgesenkten oberen Grenzfrequenz G1", G1' wird dadurch erreicht, indem die frequenzbeeinflussenden Regler, nämlich ein Bassregler 32 und/oder ein Höhenregler 33, das Audiosignal A entsprechend verändern.

Vorzugsweise erfolgt hierbei die Veränderung der unteren und der oberen Grenzfrequenz derart, daß das Produkt aus der unteren angehobenen Grenzfrequenz G1" und der abgesenkten oberen Grenzfrequenz G1' im wesentlichen gleich dem Produkt der ursprünglichen Grenzfrequenzen G0', G0" ist. Es wird weiterhin bevorzugt, daß die Steuerung der beiden Regler 32, 33 derart erfolgt, daß das Produkt aus der unteren Grenzfrequenz und der oberen Grenzfrequenz ungefähr 400.000 beträgt. Durch die vorstehend beschriebenen Maßnahmen wird auf einfache Art und Weise erreicht, daß auch bei einer störungsbedingt erforderlichen Absenkung der oberen Grenzfrequenz G1' durch eine entsprechende Anhebung der unteren Grenzfrequenz G1" ein ausgewogenes Klangbild des Audiosignals A erreicht wird, indem die beiden Enden des Audiofrequenzganges vorzugsweise gleichmäßig verändert werden.

Bevorzugt wird desweiteren, daß zusätzlich zur Absenkung der oberen und Anhebung unteren Grenzfrequenz ein Lautstärkeausgleich erfolgt, indem beim Auftreten des Steuersignals S der Lautstärkenregler 34 der Audioeinheit 30 entsprechend angesteuert wird. Hierbei wird bevorzugt, daß das zwischen den beiden Grenzfrequenzen G1', G1" bestimmte Integral des Pegels des Audiosignals A vor und nach der oben beschriebenen Modifikation im wesentlichen unverändert bleibt, so daß der über den Frequenzgang integrierte Lautstärkepegel vor und nach der Absenkung der oberen Grenzfrequenz von der ursprünglichen oberen Grenzfrequenz G0' auf die abgesenkte obere Grenzfrequenz G1' und der Anhebung der unteren Grenzfrequenz von der ursprünglichen unteren Grenzfrequenz G0" auf die angehobene untere Grenzfrequenz G1" im wesentlichen gleich ist.

Das aus der oben beschriebene Steuereinrichtung resultierende Audiosignal wird nun anhand der Figur 2 erläutert, welche den Pegel des Audiosignals A als Funktion der Frequenz des Audiosignales A (in logarithmischem Maßstab) darstellt.

Die in Figur 2 durchgezogene Linie 1 stellt den Frequenzgang eines ungestörten Audiosignals A zwischen einer unteren Grenzfrequenz G0 von 20 Hz und einer oberen Grenzfrequenz G0' von 15 kHz dar, wobei die bei den vorgenannten Werten typische Grenzwerte für hochwertige Audioanlagen darstellen. Wird nun von der Detektionseinrichtung 10 das Auftreten einer entsprechenden Empfangsstörung, vorzugsweise einer Mehrwegempfangsstörung, detektiert und von der Verarbeitungseinrichtung 20 das Steuersignal S erzeugt, so erfolgt - wie durch die strichlierte Linie 2 in Figur 2 dargestellt ist, eine Absenkung des Signalpegels des Audiosignals A1 gleichzeitig im hoch- und im niederfrequenten Frequenzbereich, da - wie oben beschrieben - sowohl eine Anhebung der unteren Grenzfrequenz G1" als auch eine Absenkung der oberen Grenzfrequenz G1' vorgenommen wird.

Tritt nun eine stärkere Empfangsstörung als im vorgenannten Fall des Audiosignals A1 auf, so wird eine noch stärkere Absenkung der oberen Grenzfrequenz auf eine abgesenkte obere Grenzfrequenz G2' und eine noch stärkere Anhebung der unteren Grenzfrequenz auf eine angehobene untere Grenzfrequenz G2" durchgeführt. Das resultierende Audiosignal A2 wird durch die in Figur 2 strichpunktierte Linie 3 charakterisiert.

Wie bereits oben erläutert, wird bei dem beschriebenen Verfahren vorzugsweise vorgesehen, daß bei einer störungsbedingten Absenkung der oberen Grenzfrequenz G0' bzw. Anhebung der unteren Grenzfrequenz G0" auf eine entsprechend modifizierte abgesenkte obere Grenzfrequenz G1', G2' bzw. angehobene untere Grenzfrequenz G1", G2" eine Lautstärkeanpassung, also eine Anhebung des Audiosignals zwischen den entsprechend modifizierten Grenzfrequenzen G1', G1" bzw. G2', G2" vorgenommen. Die Linie 3a repräsentiert nun den Signalpegel des Audiosignals A3 nach einer derartigen Pegelanhebung. Wie sich aus einem Vergleich der von der Kurve 3 und der Kurve 3a begrenzten Flächen leicht ergibt, wird hierbei die Anhebung des Pegels des Audiosignals derart vorgenommen, daß der Flächeninhalt der von der Kurve 3 begrenzten Fläche (und somit das Integral des Lautstärkepegels) zwischen den ursprünglichen Grenzfrequenzen G0', G0" im wesentlichen gleich dem den gleichen Flächeninhalt der von der Kurve 3a begrenzten Fläche zwischen den modifizierten Grenzfrequenzen G2', G2" ist.

## Patentansprüche

1. Verfahren zur Erkennung und Reduzierung von Empfangsstörungen, insbesondere von Mehrwegempfangstörungen, in einem Eingangssignal (E) eines Rundfunkempfängers, bei dem in einer Detektoreinrichtung (10) das Auftreten einer derartigen Empfangsstörung detektiert und ein entsprechendes Detektorsignal (MWS, AMS, MKS) zu einer dieses Detektorsignal (MWS, AMS, MKS) auswertenden Verarbeitungseinrichtung (20) geleitet wird, wobei von der Verarbeitungseinrichtung (20) ein entsprechendes Steuersignal (S) erzeugt und zu einer Audioeinheit (30) geleitet wird, durch die ein Audiosignal erzeugbar ist, welches in einem von einer unteren (G0") und einer oberen Grenzfrequenz (G0') begrenzten Frequenzintervall liegt, und bei dem durch die Audioeinheit (30) eine Absenkung des Pegels des von ihr aus dem Eingangssignal (E) erzeugten Audiosignals (A) im Frequenzbereich über einer unter der vorgenannten oberen Grenzfrequenz (G0') des Audiosignals (A) liegenden, abgesenkten oberen Grenzfrequenz (G1', G2') durchgeführt wird, **dadurch gekennzeichnet, daß** gleichzeitig zur Pegelabsenkung des Audiosignals (A) im Frequenzbereich über der abgesenkten oberen Grenzfrequenz (G1', G2') eine entsprechende Pegelabsenkung des Audiosignals (A) im Bereich unter einer über der vorgenannten unteren Grenzfrequenz (G0") liegenden, angehobenen unteren Grenzfrequenz (G1", G2") durchgeführt wird.

2. Verfahren nach Anspruch 1, **dadurch gekennzeichnet, daß** die Pegelabsenkung des Audiosignals (A) im Frequenzbereich über seiner abgesenkten oberen Grenzfrequenz (G1', G2') und seiner angehobenen unteren Grenzfrequenz (G1", G2") im wesentlichen gleichmäßig durchgeführt wird.

3. Verfahren nach einem der vorangehenden Ansprüche, **dadurch gekennzeichnet, daß** die Pegelabsenkung des Audiosignals (A) derart erfolgt, daß das Produkt aus der angehobenen unteren Grenzfrequenz (G1", G2") und der abgesenkten oberen Grenzfrequenz (G1', G2') im wesentlichen gleich dem Produkt der ursprünglichen oberen Grenzfrequenz (G0') und der unteren Grenzfrequenz (G0") ist.

4. Verfahren nach einem der vorangehenden Ansprüche, **dadurch gekennzeichnet, daß** das Produkt aus der angehobenen unteren Grenzfrequenz (G1", G2") und der abgesenkten oberen Grenzfrequenz (G1', G2') im wesentlichen im Größenbereich von 400.000 ist.

5. Verfahren nach einem der vorangehenden Ansprüche, **dadurch gekennzeichnet, daß** bei einer Absenkung der oberen Grenzfrequenz (G1', G2') und einer Anhebung der unteren Grenzfrequenz (G1", G2") des Audiosignals (A) eine Anhebung des Signalpegels des Audiosignals im Bereich zwischen den beiden modifizierten Grenzfrequenzen (G1', G2'; G1", G2") durchgeführt wird.

6. Verfahren nach Anspruch 5, **dadurch gekennzeichnet, daß** die Pegelanhebung des Audiosignals (A) derart erfolgt, daß das Integral des Lautstärkepegels zwischen den ursprünglichen. Grenzfrequenzen (G0' G0") im wesentlich gleich demjenigen zwischen den abgesenkten Grenzfrequenzen (G1', G1", G2', G2") ist.

7. Verfahren nach einem der vorangehenden Ansprüche, **dadurch gekennzeichnet, daß** die Pegelabsenkung des Audiosignals (A) nur dann erfolgt, wenn der Pegel des Eingangssignals (E) unter einem vordefinierten Grenzpegel liegt.

8. Verfahren nach einem der vorangehenden Ansprüche, **dadurch gekennzeichnet, daß** als Eingangssignal (E) die Feldstärke oder ein Multiplexsignal verwendet wird.

9. Verfahren nach einem der vorangehenden Ansprüche, **dadurch gekennzeichnet, daß** ein das Auftreten einer Mehrwegempfangsstörung charakterisierendes Detektorsignal (MWS) der Verarbeitungseinrichtung (20) zugeführt wird.

10. Verfahren nach einem der vorangehenden Ansprüche, **dadurch gekennzeichnet, daß** ein das Auftreten von AM-Anteilen im Eingangssignal (E) charakterisierendes Detektorsignal (AMS) der Verarbeitungseinrichtung (20) zugeführt wird.

11. Verfahren nach einem der vorangehenden Ansprüche, **dadurch gekennzeichnet, daß** ein das Auftreten von Nachbarkanalstörungen charakterisierenden Detektorsignal (NKS) der Verarbeitungsvorrichtung (20) zugeführt wird.

12. Verfahren nach einem der vorangehenden Ansprüche, **dadurch gekennzeichnet, daß** zur Absenkung des Signalpegels des Audiosignals (A) im Frequenzbereich unter der angehobenen unteren Grenzfrequenz (G1", G2") und über der abgesenkten oberen Grenzfrequenz (G1', G2') frequenzanpassende Regler (32, 33) der Audioeinheit (30) angesteuert werden.

13. Verfahren nach einem der vorangehenden Ansprüche, **dadurch gekennzeichnet, daß** zur Anhebung des Signalpegels des Audiosignals (A) im Bereich zwischen den beiden Grenzfrequenzen (G1', G1", G2', G2") ein Lautstärkenregler (34) der Audioeinheit (30) angesteuert wird.

14. Schaltungsanordnung zur Erkennung und Reduzierung von Empfangsstörungen, insbesondere von Mehrwegempfangstörungen in einem Eingangssignal (E) eines Rundfunkempfängers, der eine Detektoreinheit (10), eine Verarbeitungseinheit (20) und eine Audioeinheit (30) aufweist, wobei der Verarbeitungseinheit (20) ein das Auftreten einer Empfangsstörung charakterisierendes Detektorsignal (MWS, AMS, NKS) zugeführt wird, die daraufhin ein Steuersignal (S) erzeugt, das zur Audioeinheit (30) geleitet wird, daß beim Auftreten dieses Steuersignals (S) die Audioeinheit (30) die obere Grenzfrequenz (G0') des Audiosignals (A) auf eine abgesenkte obere Grenzfrequenz (G1', G2') absenkt, **dadurch gekennzeichnet, daß** beim Auftreten des Steuersignals (S) die Audioeinheit (30) gleichzeitig die untere Grenzfrequenz auf eine angehobene untere Grenzfrequenz (G1", G2") anhebt.

15. Kraftfahrzeug, **gekennzeichnet durch** eine Schaltungsanordnung nach Anspruch 14.

## Claims

1. Method for identifying and reducing reception interference, particularly multipath reception interference, in an input signal (E) for a broadcast radio receiver, in which a detector device (10) detects the occurrence of such reception interference and routes a corresponding detector signal (MWS, AMS, MKS) to a processing device (20) which evaluates this detector signal (MWS, AMS, MKS), where the processing device (20) produces a corresponding control signal (S) and routes it to an audio unit (30) which can produce an audio signal which is in a frequency range limited by a lower (G0") and an upper (G0') cut-off frequency, and in which the audio unit (30) lowers the level of the audio signal (A) which it has produced from the input signal (E) in the frequency range above a lowered upper cut-off frequency (G1', G2') which is below the aforementioned upper cut-off frequency (G0') of the audio signal (A), **characterized in that** simultaneously with the lowering of the level of the audio signal (A) in the frequency range above the lowered upper cut-off frequency (G1', G2') there is a corresponding lowering of the level of the audio signal (A) in the range below a raised lower cut-off frequency (G1", G2") which is above the aforementioned lower cut-off frequency (G0").

2. Method according to Claim 1, **characterized in that** the lowering of the level of the audio signal (A) in the frequency range above its lowered upper cut-off frequency (G1', G2') and its raised lower cut-off frequency (G1", G2") is carried out essentially uniformly.

3. Method according to one of the preceding claims, **characterized in that** the level of the audio signal (A) is lowered such that the product of the raised lower cut-off frequency (G1", G2") and the lowered upper cut-off frequency (G1', G2') is essentially equal to the product of the original upper cut-off frequency (G0') and the lower cut-off frequency (G0").

4. Method according to one of the preceding claims, **characterized in that** the product of the raised lower cut-off frequency (G1", G2") and the lowered upper cut-off frequency (G1', G2') is essentially in the magnitude region of 400 000.

5. Method according to one of the preceding claims, **characterized in that** lowering the upper cut-off frequency (G1', G2') and raising the lower cut-off frequency (G1", G2") of the audio signal (A) involves raising the signal level of the audio signal in the range between the two modified cut-off frequencies (G1', G2'; G1", G2").

6. Method according to Claim 5, **characterized in that** the level of the audio signal (A) is raised such that the integral of the volume level between the original cut-off frequencies (G0', G0") is essentially equal to that between the lowered cut-off frequencies (G1', G1", G2', G2").

7. Method according to one of the preceding claims, **characterized in that** the level of the audio signal (A) is lowered only when the level of the input signal (E) is below a predefined limit level.

8. Method according to one of the preceding claims, **characterized in that** the input signal (E) used is the field strength or a multiplex signal.

9. Method according to one of the preceding claims, **characterized in that** a detector signal (MWS) **characterizing** the occurrence of multipath reception interference is supplied to the processing device (20).

10. Method according to one of the preceding claims, **characterized in that** a detector signal (AMS) **characterizing** the occurrence of AM components in the input signal (E) is supplied to the processing device (20).

11. Method according to one of the preceding claims, **characterized in that** a detector signal (NKS) **characterizing** the occurrence of adjacent channel interference is supplied to the processing apparatus (20).

12. Method according to one of the preceding claims, **characterized in that** the signal level of the audio signal (A) is lowered in the frequency range below the raised lower cut-off frequency (G1", G2") and above the lowered upper cut-off frequency (G1', G2') by actuating frequency-adaptive controls (32, 33) in the audio unit (30).

13. Method according to one of the preceding claims, **characterized in that** the signal level of the audio signal (A) is raised in the range between the two cut-off frequencies (G1', G1", G2', G2") by actuating a volume control (34) in the audio unit (30).

14. Circuit arrangement for identifying and reducing reception interference, particularly multipath reception interference, in an input signal (E) for a broadcast radio receiver, which has a detector unit (10), a processing unit (20) and an audio unit (30), where the processing unit (20) is supplied with a detector signal (MWS, AMS, NKS) **characterizing** the occurrence of reception interference and then produces a control signal (S) which is routed to the audio unit (30), and where the occurrence of this control signal (S) prompts the audio unit (30) to lower the upper cut-off frequency (G0') of the audio signal (A) to a lowered upper cut-off frequency (G1', G2') , **characterized in that** the occurrence of the control signal (S) prompts the audio unit (30) to raise the lower cut-off frequency to a raised lower cut-off frequency (G1", G2") at the same time.

15. Motor vehicle, **characterized by** a circuit arrangement according to Claim 14.

## Revendications

1. Procédé pour la reconnaissance et la réduction de perturbations de réception, en particulier de perturbations de réception par trajet multiple, dans un signal d'entrée (E) d'un récepteur radio, selon lequel dans un dispositif détecteur (10) l'apparition d'une telle perturbation de réception est détectée et un signal détecté correspondant (MWS, AMS, MKS) est dirigé vers un dispositif de traitement (20) exploitant ce signal détecté (MWS, AMS, MKS), un signal de commande (S) correspondant étant généré à partir du dispositif de traitement (20) et dirigé vers une unité audio (30), dans laquelle un signal audio est susceptible d'être généré et se situe dans un intervalle de fréquences délimité par une fréquence de limite inférieure (G0") et par une fréquence de limite supérieure (G0'), et du type selon lequel dans l'unité audio (30) est réalisée une atténuation du niveau du signal audio (A), généré par elle à partir du signal d'entrée (E), dans la gamme de fréquences s'étendant au-dessus d'une fréquence atténuée de limite supérieure (G1', G2'), située au dessous de la fréquence précitée de limite supérieure (G0'), **caractérisé en ce que** simultanément à l'atténuation du niveau du signal audio (A) dans la gamme de fréquences s'étendant au-dessus de la fréquence atténuée de limite supérieure (G1', G2'), est réalisée une atténuation correspondante du niveau du signal audio (A) dans la gamme s'étendant au dessous d'une fréquence accentuée de limite inférieure (G1", G2"), située au-dessus de la fréquence précitée de limite inférieure (G0").

2. Procédé selon la revendication 1, **caractérisé en ce que** l'atténuation du niveau du signal audio (A) est réalisée de manière substantiellement symétrique dans la gamme de fréquences s'étendant au-dessus de sa fréquence atténuée de limite supérieure (G1', G2') et de sa fréquence accentuée de limite inférieure (G1'', G2'').

3. Procédé selon l'une des revendications précédentes, **caractérisé en ce que** l'atténuation du niveau du signal audio (A) intervient de telle sorte que le produit de la fréquence accentuée de limite inférieure (G1", G2") par la fréquence atténuée de limite supérieure (G1', G2') est substantiellement égal au produit des fréquences d'origine de limite supérieure (G0') et de limite inférieure (G0" ) .

4. Procédé selon l'une des revendications précédentes, **caractérisé en ce que** le produit de la fréquence accentuée de limite inférieure (G1", G2") par la fréquence atténuée de limite supérieure (G1', G2') est substantiellement de l'ordre de grandeur de 400.000.

5. Procédé selon l'une des revendications précédentes, **caractérisé en ce que** lors d'une atténuation de la fréquence de limite supérieure (G1', G2') et d'une accentuation de la fréquence de limite inférieure (G1'', G2") du signal audio (A), est réalisée une accentuation du niveau du signal audio dans la gamme située entre les deux fréquences modifiées de limite (G1' , G2' ; G1" , G2").

6. Procédé selon la revendication 5, **caractérisé en ce que** l'accentuation du niveau du signal audio (A) intervient de telle sorte que l'intégrale du niveau de puissance sonore entre les fréquences limites d'origine (G0', G0'') est substantiellement égale à celle entre les fréquences limites atténuées (G1', G1'', G2', G2").

7. Procédé selon l'une des revendications précédentes, **caractérisé en ce que** l'atténuation du niveau du signal audio (A) n'intervient dès lors que si le niveau du signal d'entrée (E) se situe sous un niveau limite prédéfini.

8. Procédé selon l'une des revendications précédentes, **caractérisé en ce qu'**en tant que signal d'entrée (E) on utilise l'intensité du champ ou un signal de multiplexage.

9. Procédé selon l'une des revendications précédentes, **caractérisé en ce qu'**un signal détecté (MWS), caractérisant l'apparition d'une perturbation de réception par trajet multiple, est introduit dans le dispositif de traitement (20).

10. Procédé selon l'une des revendications précédentes, **caractérisé en ce qu'**un signal détecté (AMS), caractérisant l'apparition de composantes AM (modulation d'amplitude) dans le signal d'entrée (E), est introduit dans le dispositif de traitement (20).

11. Procédé selon l'une des revendications précédentes, **caractérisé en ce qu'**un signal détecté (NKS), caractérisant l'apparition de perturbations issues de canaux voisins, est introduit dans le dispositif de traitement (20).

12. Procédé selon l'une des revendications précédentes, **caractérisé en ce que** pour l'atténuation du niveau du signal audio (A) dans la gamme de fréquences s'étendant au dessous de la fréquence accentuée de limite inférieure (G1", G2") et au-dessus de la fréquence atténuée de limite supérieure (G1', G2'), on active des régulateurs adaptateurs de fréquence (32, 33) de l'unité audio (30).

13. Procédé selon l'une des revendications précédentes, **caractérisé en ce que** pour l'accentuation du niveau du signal audio (A) dans la gamme située entre les deux fréquences limites (G1', G1", G2', G2"), on active un régulateur de puissance sonore (34) de l'unité audio (30).

14. Circuit pour la reconnaissance et la réduction de perturbations de réception, en particulier de perturbations de réception par trajet multiple dans un signal d'entrée (E) d'un récepteur radio, qui comprend une unité de détection (10), une unité de traitement (20) et une unité audio (30), du type selon lequel un signal détecté (MWS, AMS, NKS), caractérisant l'apparition d'une perturbation de réception, est introduit dans l'unité de traitement (20) et y génère un signal de commande (S), qui est dirigé vers l'unité audio (30), de telle façon que lors de l'apparition de ce signal de commande (S), l'unité audio (30) atténue la fréquence limite supérieure (G0') du signal audio (A) jusqu'à une fréquence atténuée de limite supérieure (G1', G2'), **caractérisé en ce que** lors de l'apparition du signal de commande (S), l'unité audio (30) accentue simultanément la fréquence de limite inférieure jusqu'à une fréquence accentuée de limite inférieure (G1", G2").

15. Véhicule **caractérisé par** un circuit selon la revendication 14.
